# FASCICULE DE BREVET EUROPEEN

(11) **EP 0 526 359 B1**
(45) Date de publication et mention de la délivrance du brevet: **25.09.1996**
(21) Numéro de dépôt: 92420253.4
(22) Date de dépôt: 27.07.1992
(51) Int. Cl.: H03L 7/099, H03L 7/10

(54) **Procédé et dispositif de synchronisation d'un signal**
Verfahren und Schaltungsanordnung zur Synchronisierung eines Signals
Process and circuit arrangement for synchronising a signal

(30) Priorité: 30.07.1991 FR 9109925
(43) Date de publication de la demande: 03.02.1993
(73) Titulaire: SGS-THOMSON MICROELECTRONICS S.A., F-94250 Gentilly (FR)
(72) Inventeur: Meyer, Jacques, F-38700 Corenc (FR)
(74) Mandataire: de Beaumont, Michel

(56) Documents cités:
- EP-A- 0 316 878
- DE-A- 2 453 213
- ELECTRONICS AND COMMUNICATIONS IN JAPAN. vol. 73, no. 8, Août 1990, NEW YORK US pages 49 - 55 XU GUONAI 'Phase-Locked Loop with a Binary Quantized Phase and Frequency Comparator'

## Description

La présente invention concerne les boucles à verrouillage de phase et en particulier une boucle à verrouillage de phase numérique.

Une boucle à verrouillage de phase, couramment appelée PLL (du terme anglo-saxon " Phase Locked Loop") est un dispositif délivrant un signal synchronisé sur un signal de référence, c'est-à-dire ayant même phase et fréquence que le signal de référence. En l'absence du signal de référence, le PLL délivre un signal de fréquence approximativement égale à la fréquence nominale du signal de référence, le but du PLL étant de suivre le signal de référence et de fournir un signal semblable au signal de référence en cas d'absence accidentelle de ce dernier.

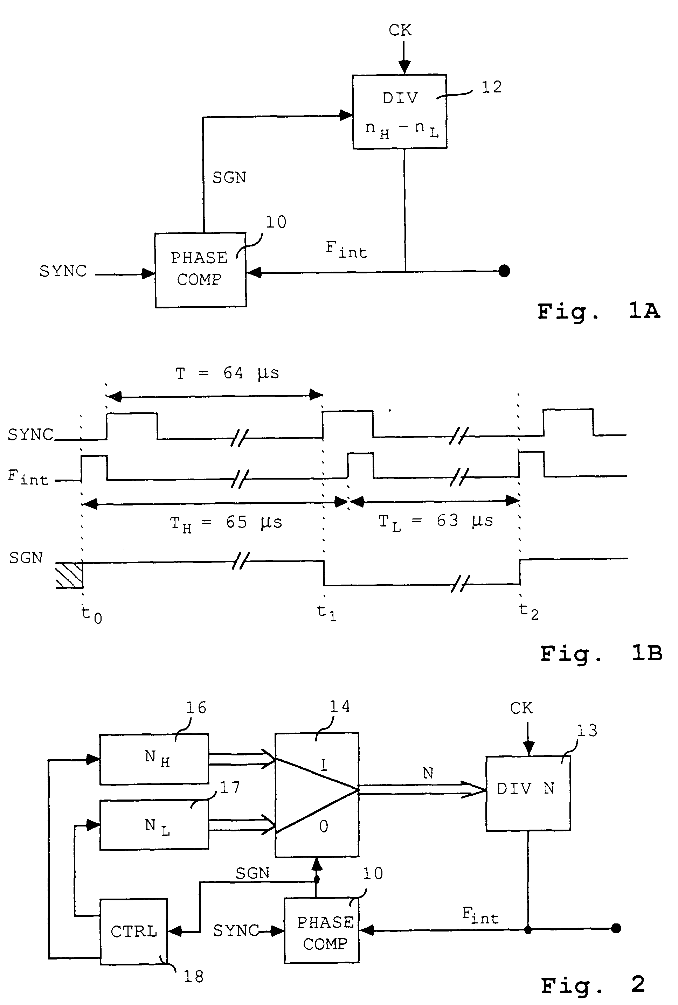

La figure 1A illustre un schéma classique de PLL numérique simple, destiné à synchroniser les impulsions d'un signal interne Fint sur les impulsions d'un signal de référence SYNC. Ce PLL comprend un comparateur de phase numérique (PHASE-COMP) 10 recevant les signaux Fint et SYNC et délivrant à sa sortie un signal SGN. Le signal SGN prend un premier état logique (1) si le signal Fint est en avance de phase par rapport au signal SYNC, c'est-à-dire si une impulsion du signal Fint survient avant une impulsion du signal SYNC, et prend un deuxième état (0) si le signal Fint est en retard de phase. Le signal Fint est obtenu par division d'un signal d'horloge CK à travers un diviseur (DIV N_{H}-N_{L}) 12 piloté par le signal SGN du comparateur de phase. Le diviseur 12 divise le signal CK par un nombre haut fixe N_{H} lorsque le signal SGN est à "1" et par un nombre bas fixe N_{L} lorsque le signal SGN est à "0".

Le nombre N_{H} est tel que le signal Fint obtenu par division du signal d'horloge CK par ce nombre N_{H} ait une période supérieure à la période nominale du signal de référence SYNC. Le nombre N_{L} est tel que le signal Fint ait une période inférieure à la période nominale du signal de référence SYNC.

La figure 1B illustre les signaux SYNC, Fint et SGN dans un exemple d'application du PLL de la figure 1A à des signaux de télévision où le signal Fint est utilisé pour générer le balayage horizontal d'écran. Le signal SYNC provient alors d'un circuit de réception ou d'un magnétoscope et sa période nominale est de 64 microsecondes.

La période T du signal SYNC, notamment dans le cas d'un magnétoscope où elle est déterminée par la vitesse de défilement de la bande, peut fluctuer dans une plage assez importante. Le nombre N_{H} est choisi pour que le signal Fint correspondant ait une période longue T_{H} supérieure à la période maximale du signal SYNC, par exemple 65 microsecondes. Le nombre N_{L} est choisi pour que le signal Fint correspondant ait une période courte T_{L} inférieure à la période minimale, par exemple 63 microsecondes.

La figure 1B illustre les signaux obtenus en régime établi en supposant que le signal SYNC est à sa période nominale de 64 microsecondes.

A un instant t0, une impulsion du signal Fint est détectée avant une impulsion de synchronisation du signal SYNC, ce qui indique que le signal Fint est en avance de phase par rapport au signal SYNC. Le signal SGN du comparateur de phase passe à l'état "1" et sélectionne la division du signal d'horloge CK par le nombre haut N_{H}. La période suivante du signal Fint est donc fixée à 65 microsecondes.

A un instant t1, on détecte l'impulsion de synchronisation suivante du signal SYNC avant une impulsion du signal Fint. Ceci indique que le signal Fint est en retard de phase par rapport au signal SYNC. Le signal SGN passe à l'état "0" et sélectionne la division par le nombre bas N_{L} et donc une période du signal Fint de 63 microsecondes.

A un instant t2, une impulsion du signal Fint est détectée avant l'impulsion de synchronisation suivante du signal SYNC, indiquant un retard de phase. Le signal SGN bascule à l'état "1" et le processus se répète comme à l'instant t0.

Dans le cas ci-dessus où la période T du signal de référence SYNC est constante et égale à la moyenne des périodes longue et courte du signal Fint, la période du signal Fint oscille à chaque période entre 63 et 65 microsecondes.

Si la période T est légèrement supérieure à 64 microsecondes, la période du signal Fint oscille de la même façon avec toutefois, de temps en temps, quelques périodes successives de 65 microsecondes. Si la période T est légèrement inférieure à 65 microsecondes, le signal Fint aura une période de 65 microsecondes avec de temps en temps une période de 63 microsecondes. En fait, les périodes longues ou courtes du signal Fint se succèdent de manière que la fréquence moyenne prise sur un grand nombre de périodes du signal Fint soit égale à celle du signal SYNC. On peut montrer que le rapport cyclique du signal SGN s'exprime par (T-T_{L})/(T_{H}-T_{L}).

Si la période T est supérieure à 65 microsecondes, la période du signal Fint se bloque à 65 microsecondes et est donc erronée.

Les cas complémentaires se produisent lorsque la période T est comprise entre 63 et 64 microsecondes.

Ainsi, ce PLL est capable de suivre un signal de référence SYNC seulement si sa période T est comprise entre des limites déterminées (ici 63 et 65 microsecondes). On a donc intérêt à écarter le plus possible les périodes extrêmes du signal Fint pour agrandir la plage de poursuite.

Toutefois, en augmentant cet écart, on diminue la résolution du PLL. En effet, en supposant que le signal SYNC est le signal de synchronisation de balayage horizontal d'un téléviseur, les sauts de période entre les périodes extrêmes du signal Fint, à partir duquel le balayage est généré, se traduisent par des lignes sur l'écran débutant alternativement en avance ou en retard l'une par rapport à l'autre. Si les périodes extrêmes du signal Fint sont trop grandes, ces décalages de ligne deviennent gênants car visibles à l'oeil nu (une verticale se met à ressembler à des créneaux).

Un objet de la présente invention est de prévoir un PLL numérique simple ayant une grande plage de poursuite et une bonne résolution.

Cet objet est atteint grâce à un procédé de synchronisation d'un signal prédéterminé sur un signal de référence ayant une période de référence, le signal prédéterminé ayant une période longue ou une période courte entre lesquelles est normalement comprise la période de référence, comprenant les étapes suivantes :
a) analyser la durée de la période de référence par rapport aux durées des périodes longue et courte ;
b) si la période de référence est plus proche de la période longue que de la période courte, incrémenter la période courte ;
c) si la période de référence est plus proche de la période courte que de la période longue, décrémenter la période longue ;
d) si la période de référence est supérieure à la période longue, incrémenter la période longue ; et
e) si la période de référence est inférieure à la période courte, décrémenter la période courte.

Selon un mode de réalisation de la présente invention, l'étape a) consiste à analyser un nombre prédéterminé des dernières différences de phase successives entre le signal prédéterminé et le signal de référence et les conditions des étapes b) à e) sont réalisées respectivement si, parmi les dernières différences de phase :
- le nombre d'avances de phase est plus élevé que le nombre de retards de phase ;
- le nombre de retards de phase est plus élevé que le nombre d'avances de phase ;
- il n'y a pas de retards de phase ; et
- il n'y a pas d'avances de phase.

Selon un mode de réalisation de la présente invention, il est prévu que, si le nombre d'avances de phase successives est supérieur à un nombre prédéterminé, on incrémente la période longue ; et, si le nombre de retards de phase successifs est supérieur au nombre prédéterminé, on décrémente la période courte.

Selon un mode de réalisation de la présente invention, il est prévu les étapes consistant à comparer les périodes longue et courte et à inhiber la décrémentation de la période longue et l'incrémentation de la période courte quand la différence entre ces périodes est inférieure à un seuil prédéterminé.

Selon un mode de réalisation de la présente invention, il est prévu les étapes consistant à comparer la période longue à une période maximale et inhiber l'incrémentation de la période longue si ces périodes sont égales ; et comparer la période courte à une période minimale et inhiber la décrémentation de la période courte si ces périodes sont égales.

La présente invention prévoit aussi un dispositif de synchronisation d'un signal interne sur un signal de référence, ces signaux comprenant chacun des impulsions se produisant normalement à une fréquence nominale, comprenant un comparateur de phase délivrant un signal de comparaison de phase à un état logique prédéterminé si la phase du signal interne est en avance par rapport à celle du signal de synchronisation, et à un état logique complémentaire dans le cas contraire ; un diviseur de fréquence programmable alimenté par une horloge et délivrant le signal interne ; un multiplexeur fournissant au diviseur pour le programmer un nombre binaire haut si ledit signal de comparaison est à un état prédéterminé, et un nombre binaire bas dans le cas contraire ; des moyens pour mémoriser séquentiellement les derniers états du signal de comparaison ; des premiers moyens de comptage/décomptage cadencés par le signal interne et fournissant ledit nombre binaire haut au multiplexeur ; des premiers moyens de détection mettant les premiers moyens de comptage/décomptage en position de décomptage lorsque les derniers états mémorisés du signal de comparaison présentent un seul état à l'état prédéterminé ; des deuxièmes moyens de comptage/décomptage cadencés par le signal interne et fournissant ledit nombre binaire bas au multiplexeur ; et des deuxièmes moyens de détection mettant les deuxièmes moyens de comptage/décomptage en position de comptage lorsque les derniers états mémorisés du signal de comparaison présentent un seul état à l'état complémentaire.

Selon un mode de réalisation de la présente invention, ce dispositif comprend en outre des troisièmes moyens de détection mettant les premiers moyens de comptage/décomptage position de comptage lorsque les états mémorisés du signal de comparaison sont tous à l'état prédéterminé ; et des quatrièmes moyens de détection mettant les deuxièmes moyens de comptage/décomptage en position de décomptage lorsque les états mémorisés du signal de comparaison sont tous à l'état complémentaire.

Selon un mode de réalisation de la présente invention, ce dispositif comprend en outre un premier comparateur des nombres binaires haut et bas et mettant les premiers et deuxièmes moyens de comptage/décomptage en position de repos si le nombre haut est inférieur ou égal au nombre bas.

Selon un mode de réalisation de la présente invention, ce dispositif comprend en outre un deuxième comparateur du nombre binaire haut à un nombre binaire maximum et mettant les premiers moyens de comptage/décomptage à la position de repos en cas de dépassement ; et un troisième comparateur du nombre binaire bas à un nombre minimum et mettant les deuxièmes moyens de comptage/décomptage à la position de repos en cas de dépassement.

Selon un mode de réalisation de la présente invention, le diviseur programmable comprend un diviseur par deux nombres distincts dont l'un ou l'autre est sélectionné par le signal de sortie d'un générateur d'impulsions programmé par le nombre fourni par le multiplexeur.

Ces objets, caractéristiques et avantages de la présente invention ainsi que d'autres seront exposés plus en détail dans la description suivante de modes de réalisation particuliers faite en relation avec les dessins joints parmi lesquels :
les figures 1A et 1B, précédemment décrites, représentent respectivement un PLL numérique classique et des signaux relatifs à ce PLL ;
La figure 2 représente un schéma simplifié d'un PLL numérique selon la présente invention ;
la figure 3 illustre un exemple de réalisation détaillé du PLL de la figure 2 ; et
la figure 4 illustre un mode de réalisation d'un diviseur programmable utilisable dans le PLL des figures 2 et 3.

Dans un système de synchronisation à boucle à verrouillage de phase du type de celui de la figure 1A, le procédé selon la présente invention consiste à modifier les périodes longue T_{H} et courte T_{L} du signal Fint de manière à les rapprocher le plus possible d'une période en cours T stable du signal SYNC en veillant à ce que cette dernière soit encadrée par les périodes longue et courte. Cela est effectué de la manière suivante.

A la suite d'un glissement de la fréquence du signal SYNC, la période T de ce dernier ne se trouve plus entre les périodes longue et courte du signal Fint. Si elle est, par exemple, supérieure à la période longue, cette période longue est incrémentée jusqu'à ce qu'elle redevienne supérieure à la période T. Si la période T est inférieure à la période courte, cette période courte est décrémentée jusqu'à ce qu'elle redevienne inférieure à la période T. Ensuite, on rapproche la période du signal Fint la plus éloignée de la période T jusqu'à ce que l'autre période du signal Fint se trouve être la plus éloignée, et ainsi de suite jusqu'à ce que les périodes longue et courte soient distantes l'une de l'autre d'une valeur minimum déterminée tout en encadrant la période T.

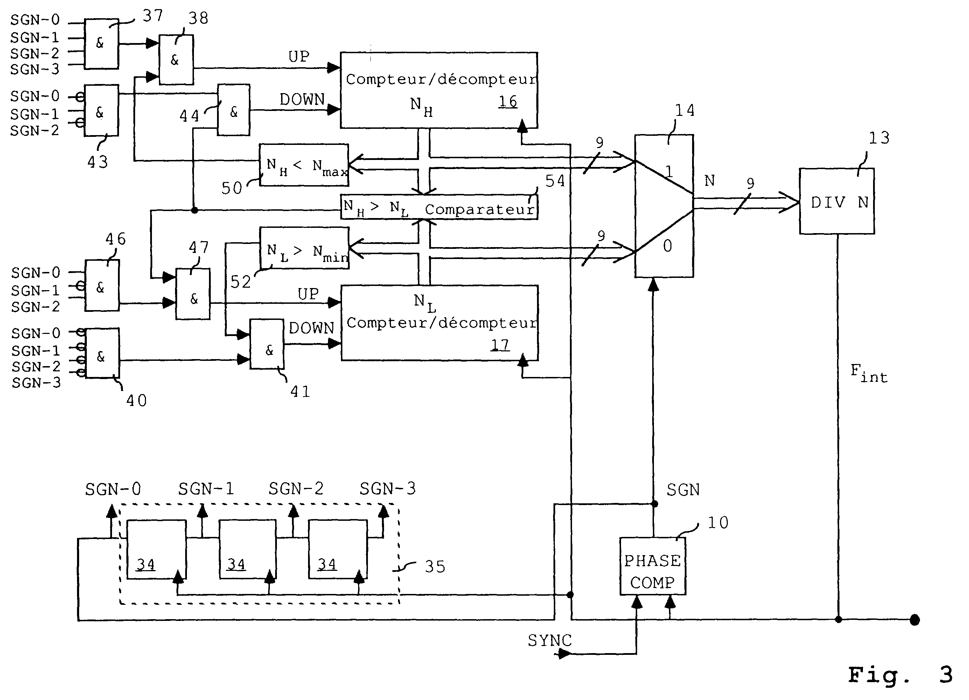

La figure 2 illustre un schéma simplifié d'un PLL selon un mode de réalisation de la présente invention permettant cette modification des périodes longues et courtes du signal Fint par des modifications adéquates des nombres de division N_{H} et N_{L} de la figure 1A. Ce PLL comprend un comparateur de phase numérique 10, identique à celui utilisé dans le PLL classique de la figure 1A, recevant les signaux SYNC et Fint et délivrant le signal SGN. Le signal Fint est obtenu par division d'un signal d'horloge CK à travers un diviseur par N programmable (DIV N) 13. Le diviseur 13 comprend une entrée de programmation sur laquelle est présenté le nombre N. Ce nombre N est fourni par un multiplexeur 14 à deux entrées. L'état "1" du signal SGN sélectionne la première entrée du multiplexeur 14 sur laquelle est présenté le nombre haut N_{H} mémorisé dans une mémoire 16. L'état "0" du signal SGN sélectionne la deuxième entrée du multiplexeur sur laquelle est présenté le nombre bas N_{L} mémorisé dans une mémoire 17.

Les éléments du PLL selon l'invention décrits ci-dessus ont les mêmes fonctions que ceux du PLL classique de la figure 1A et ont le même but de générer un signal Fint avec des périodes courtes T_{L} et longues T_{H} se succédant de telle manière que la période moyenne du signal Fint prise sur un grand nombre de périodes soit égale à la période T du signal SYNC.

Le diviseur par N_{H} ou par N_{L} 12 classique a été remplacé par le diviseur programmable 13 auquel on fournit de l'extérieur l'un ou l'autre des nombres N_{H} et N_{L} par l'intermédiaire du multiplexeur 14 commuté par le signal SGN. Ainsi, en modifiant les nombres N_{H} et N_{L} on modifie les périodes T_{H} et T_{L} de la manière précédemment décrite. On va décrire plus en détail ci-après un procédé de modification des nombres N_{H} et N_{L} selon un mode de réalisation particulier de la présente invention.

Un circuit de commande (CTRL) 18 fait incrémenter ou décrémenter les nombres N_{H} et N_{L} dans les mémoires 16 et 17 en fonction de la succession des états du signal SGN. Le circuit 18 analyse les derniers états successifs du signal SGN dans une fenêtre d'un nombre prédéterminé de périodes, par exemple 4. L'interprétation des états du signal SGN permet de détecter les cas suivants et de provoquer des opérations correspondantes.
a) Le signal SGN présente des états alternant entre "1" et "0" (son rapport cyclique est de 0,5). Comme cela a été mentionné en relation avec la figure 1B, la période T du signal SYNC est alors centrée entre les périodes courte T_{L} et longue T_{H} du signal Fint. Ces alternances du signal SGN sont détectées dans la fenêtre d'analyse et on décrémente le nombre haut N_{H} une période sur deux en incrémentant le nombre bas N_{L} lors de chacune des autres périodes. Ainsi, on obtient une convergence rapide des périodes longue T_{H} et courte T_{L} du signal Fint vers la période T du signal SYNC.
b) Le signal SGN est continuellement à "1" (le signal Fint résultant est bloqué sur la période longue). Ceci indique que la période longue T_{H} du signal Fint est inférieure à la période courante T du signal SYNC ou tout au moins insuffisante pour récupérer rapidement le retard de phase. Lorsque le signal SGN aura été pendant, par exemple, 4 périodes à "1" le nombre haut N_{H} est incrémenté d'une unité à chacune des périodes ultérieures jusqu'à ce que le signal SGN soit détecté à "0".
c) Le signal SGN présente des successions de "1" entrecoupées d'un " 0" de temps en temps (son rapport cyclique est proche de 1). Ceci indique que la période longue T_{H} est supérieure à la période T mais plus proche de celle-ci que la période courte T_{L}. A chaque fois que le "0" est détecté le nombre bas N_{L} est incrémenté d'une unité pour rapprocher la période courte T_{L} des périodes T et T_{H}. Ainsi, le nombre de "1" successifs diminue de sorte que la période moyenne du signal résultant Fint reste égale à la période T, jusqu'au moment où l'on aura des "1" et des "0" alternés.

Toutefois, dans le cas où le nombre de "1" serait très important, le nombre bas N_{L} serait incrémenté très lentement. Pour accélérer la convergence, on procède de préférence comme suit. Comme dans le cas b), le nombre haut N_{H} sera incrémenté pour chaque période ultérieure à la période où l'on aura détecté 4 "1" successifs dans la fenêtre d'analyse. Ceci provoque un centrage rapide de la période T entre les périodes longue T_{H} et courte T_{L}. En effet, on obtient alors une modification de l'un ou l'autre des nombres N_{H} et N_{L} à toutes les périodes excepté les 4 périodes à "1" succédant un "0" du signal SGN. Lorsque la période T est centrée, on se trouve dans le cas a ) ci-dessus où la convergence est rapide.

Les cas d) et e) ci-dessous correspondent aux cas complémentaires des cas b) et c) et les mêmes raisonnements sont valables.
d) Le signal SGN est continuellement à "0". Ceci indique que la période courte T_{L} est supérieure à la période T. Lorsque le signal SGN aura été pendant 4 périodes à "0" le nombre bas N_{L} est décrémenté d'une unité à chacune des périodes ultérieures, jusqu'à ce que le signal SGN soit détecté à "1".
e) Le signal SGN présente des successions de "0" entrecoupées d'un "1" de temps en temps (son rapport cyclique est proche de 0). Ceci indique que la période courte T_{L} est inférieure à la période T mais plus proche de celle-ci que la période longue T_{H}. A chaque fois que le "1" est détecté le nombre haut N_{H} est décrémenté d'une unité. Le nombre bas N_{L} est incrémenté pour chaque période ultérieure à la période où l'on aura détecté 4 "0" successifs dans la fenêtre d'analyse, jusqu'au moment où l'on aura des "1" et des "0" alternés.

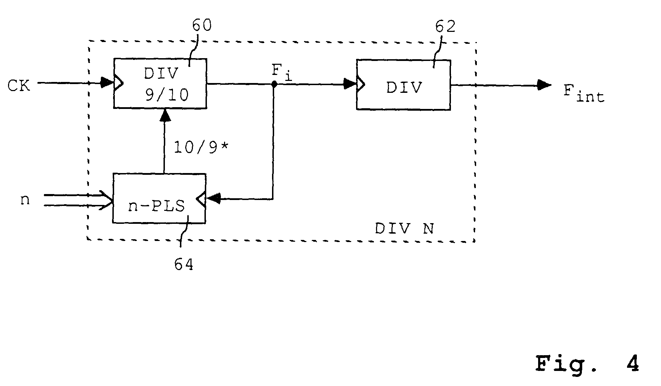

Bien entendu, le PLL selon l'invention fonctionne pourvu que certaines conditions soient respectées. Notamment, on doit avoir N_{H}>N_{L} et il faut par conséquent éviter de décrémenter le nombre N_{H} ou d'incrémenter le nombre N_{L} lorsqu'ils ne diffèrent que d'une unité à l'étape a). On verra en relation avec la figure 3 comment ces conditions sont respectées.

La figure 3 illustre un mode de réalisation détaillé du PLL de la figure 2. On retrouve le comparateur de phase 10, le multiplexeur 14 et le diviseur programmable 13 de la figure 2. Les mémoires 16 et 17 contenant les nombres haut N_{H} et bas N_{L} sont des compteurs/décompteurs cadencés par le signal Fint provenant du diviseur programmer ble 13. Les autres éléments décrits ci-après constituent le circuit de commande 18 de la figure 2.

Les trois derniers états SGN₋₁, SGN₋₂ et SGN₋₃ du signal de sortie SGN du comparateur de phase 10 sont stockés dans trois bascules 34 d'un registre à décalage 35, SGN₀ l'état du signal SGN courant. Le registre à décalage 35 est cadencé par le signal Fint et constitue la fenêtre d'analyse précédemment mentionnée.

Les états SGN₀ à SGN₋₃ sont respectivement appliqués aux entrées d'une porte ET 37 à quatre entrées, dont la sortie est reliée par l'intermédiaire d'une porte ET 38 à deux entrées à l'entrée de validation de comptage (UP) du compteur/décompteur 16.

Les complémentaires des états SGN₀ à SGN₋₃ sont appliqués respectivement aux entrées d'une porte ET 40 à quatre entrées, dont la sortie est reliée par l'intermédiaire d'une porte ET 41 à deux entrées à l'entrée de validation de décomptage (DOWN) du compteur/décompteur 17.

Le complémentaire de l'état SGN₀, l'état SGN₋₁, et le complémentaire de l'état SGN₋₂ sont respectivement appliqués aux entrées d'une porte ET 43 à trois entrées, dont la sortie est reliée par l'intermédiaire d'une porte ET 44 à deux entrées à l'entrée de validation de décomptage (DOWN) du compteur/décompteur 16.

L'état SGN₀, le complémentaire de l'état SGN₋₁, et l'état SGN₋₂ sont respectivement appliqués aux entrées d'une porte ET 46 à trois entrées, dont la sortie est reliée par l'intermédiaire d'une porte ET 47 à deux entrées à l'entrée de validation de comptage par incréments (UP) du compteur/décompteur 17.

Dans un premier temps, on ne tiendra pas compte des portes ET 38, 41, 44 et 47 et d'autres éléments non encore décrits du circuit car ils n'influent pas sur le fonctionnement principal du PLL. On suppose que les sorties des portes ET 37, 40, 43 et 46 sont directement reliées aux entrées de validation de comptage par incréments et décréments des compteurs/décompteurs 16 et 17 et que le nombre N_{H} est supérieur au nombre N_{L}. Le fonctionnement du PLL selon la présente invention est décrit ci-après en relation avec la figure 3.

Quatre "1" consécutifs du signal SGN, ce qui correspond aux cas b) et c) précédemment mentionnés, sont détectés par la porte ET 37 qui valide le comptage du compteur 16 et donc l'incrémentation d'une unité du nombre N_{H} à l'impulsion suivante du signal Fint.

Quatre "0" consécutifs du signal SGN, ce qui correspond aux cas d) et e) précédemment mentionnés, sont détectés par la porte ET 40 qui valide le décomptage du compteur 17 et donc la décrémentation d'une unité du nombre N_{L} à l'impulsion suivante du signal Fint.

Une succession d'états 1, 0, 1 du signal SGN, ce qui correspond aux cas a) et c) précédemment mentionnés, est détectée par la porte 46 qui valide le comptage du compteur 17 et donc l'incrémentation du nombre N_{L} à l'impulsion suivante du signal Fint.

Une succession d'états 0, 1, 0 du signal SGN, ce qui correspond aux cas a) et e) précédemment mentionnés, est détectée par la porte 43 qui valide le décomptage du compteur 16 et donc la décrémentation du nombre N_{H} à l'impulsion suivante du signal Fint.

Le circuit selon la présente invention comprend des éléments additionnels parmi lesquels on a cité les portes ET 38, 41, 44 et 47, permettant d'éviter que les nombres N_{H}>Nmax et N_{L} prennent des valeurs erronées, à savoir N_{H}>Nmax, N_{L}<Nmin, et N_{H}<N_{L}. Les nombres Nmax et Nmin désignent respectivement les nombres correspondant aux périodes extrêmes du signal Fint, entre lesquelles est supposée fluctuer la période du signal SYNC.

Pour éviter que le compteur 16 compte au-delà de Nmax, sa sortie (N_{H}) est reliée à un comparateur 50 qui compare le nombre N_{H} à Nmax et inhibe la validation de comptage (UP) du compteur 16 en présentant un état "0" sur la deuxième entrée de la porte ET 38 lorsque N_{H}>Nmax.

Pour éviter que le compteur 17 décompte en-deçà de Nmin, la sortie (N_{L}) du compteur est reliée à un comparateur 52 qui compare le nombre N_{L} à Nmin et inhibe la validation de décomptage (DOWN) du compteur 17 en présentant un état "0" sur la deuxième entrée de la porte ET 41 lorsque N_{L}<Nmin.

Les nombres N_{H} et N_{L} sont également comparés dans un comparateur 54 qui inhibe l'entrée de validation de comptage par décréments (DOWN) du compteur 16 et la validation de comptage par incréments (UP) du compteur 17 en présentant un "0" sur les deuxièmes entrées des portes ET 44 et 47 lorsque N_{H}<N_{L}.

Les nombres N_{H} et N_{L} sont des nombres restant voisins d'un nombre grand, de l'ordre de 7000 dans un exemple pratique que l'on décrira ci après. Stocker des nombres grands peu variables dans les compteurs 16 et 17 n'est pas avantageux car il faudrait des compteurs à grand nombre de bits. On préfère stocker dans les compteurs 16 et 17 des nombres intermédiaires haut n_{H} et bas n_{L} compris entre 0 et un nombre codable sur un nombre de bits acceptable, ces nombres étant ensuite fournis à un diviseur programmable particulier qui calcule à partir de ces nombres le facteur de division N adéquat.

On pourrait simplement obtenir N_{H} et N_{L} en ajoutant à n_{H} et n_{L} un nombre constant.

La figure 4 illustre une réalisation différente, équivalente, du diviseur programmer ble et est destinée à montrer que la présente invention est susceptible de nombreuses variantes de réalisation. Le diviseur programmable de la figure 4 comprend un diviseur par 9 ou par 10 (DIV 9/10) 60 recevant en entrée le signal d'horloge CK et délivrant un signal intermediaire Fi. La division par 9 ( c'est-à-dire la fourniture d'une impulsion toutes les neuf impulsions du signal d'horloge CK) ou par 10 (c'est-à-dire la fourniture d'une impulsion toutes les dix impulsions du signal CK) est sélectionnée par un signal 10/9^{*}. L'état "1" de ce signal provoque la division par 10 et l'état "0" provoque la division par 9. Le signal Fint est obtenu à partir du signal intermédiaire Fi en divisant ce dernier par un diviseur 62.

Le signal 10/9^{*} est fourni par un générateur d'impulsions programmable (n-PLS) 64 recevant en entrée le signal intermédiaire Fi et programmé par un nombre n qui est l'un des nombres intermédiaires n_{H} et n_{L} précédemment mentionnés fournis par le multiplexeur 14 (figures 2 et 3). Chaque fois qu'il se sera produit un nombre prédéterminé (supérieur à n) d'impulsions du signal d'entrée Fi, le générateur d'impulsions 64 n'en aura transmis sur sa sortie que n.

Dans un exemple adapté à la télévision, le signal d'horloge CK a une fréquence de 111 MHz, le diviseur 62 est un diviseur par 768, et le générateur d'impulsions 64 est un générateur de n impulsions parmi 1024 impulsions du signal Fi, le nombre n fourni par les compteurs 16 ou 17 étant un nombre binaire compris entre 0 et 511 (codé sur 9 bits).

Avec cette configuration de diviseur, le signal Fi présente des successions de 1024 impulsions dont n sont écartées l'une de l'autre de 10 périodes du signal d'horloge CK et dont 1024-n sont écartées l'une de l'autre de 9 périodes du signal CK. Le signal Fint présente une impulsion toutes les 768 impulsions du signal Fi.

Ainsi, la fréquence du signal Fint est égale à celle du signal d'horloge CK divisée par N = 768[(n/1024) + 9]. Si n=256, on a N=7104 et la fréquence du signal Fint est égale à la fréquence horizontale nominale de 15625 Hz.

Lorsque ce diviseur est utilisé dans le PLL selon la présente invention, dès que les nombres intermédiaires haut n_{H} et bas n_{L} sont différents d'une unité, la différence entre la période longue et la période courte du signal Fint est de 6, 7 nanosecondes, ce qui correspond à un décalage imperceptible sur un écran de téléviseur.

En outre, le PLL selon la présente invention peut suivre un signal SYNC ayant une période variable entre 62,3 et 65,7 microsecondes (correspondant respectivement à n_{L} = 0 et n_{H} = 511). Ces périodes extrêmes peuvent être écartées en prenant des compteurs/décompteurs et un diviseur programmable avec un plus grand nombre de bits, et en diminuant le facteur de division du diviseur 62. La différence minimum entre périodes courte et longue peut être réduite en prenant un signal d'horloge CK de fréquence supérieure et en augmentant le facteur de division du diviseur 62.

Dans le mode de réalisation décrit en relation avec la figure 3, on a choisi de détecter au bout de quatre périodes (portes ET 37, 40) une avance ou un retard de phase durable du signal Fint. L'apparition d'une phase différente occasionnelle est détectée sur trois périodes (portes ET 43, 46). On pourrait également choisir des détections sur trois périodes dans les deux cas.

La présente invention a été décrite en relation avec des signaux de télévision, mais l'homme de l'art notera que ce circuit est un PLL numérique qui peut être utilisé à la place de tout PLL en adaptant la fréquence de l'horloge CK, les taux de division des diviseurs et les écarts entre les nombres N_{H} et N_{L}. De nombreuses variantes et modifications de la présente invention apparaîtront à l'homme de l'art, par exemple, les compteurs, les portes logiques et les diviseurs peuvent être réalisés en programmant convenablement un microprocesseur et le registre à décalage 35 peut être remplacé par des cases d'une mémoire. On peut envisager d'autres circuits logiques réalisant les mêmes fonctions que celles des circuits logiques décrits.

## Revendications

1. Procédé de synchronisation d'un signal prédéterminé (Fint) sur un signal de référence (SYNC) ayant une période de référence (T), le signal prédéterminé ayant une période longue (T_{H}) ou une période courte (T_{L}) entre lesquelles est normalement comprise la période de référence (T), comprenant l'étape consistant à :
a) analyser la durée de la période de référence (T) par rapport aux durées des périodes longue (T_{H}) et courte (T_{L}) ;
caractérisé en ce qu'il comprend les étapes suivantes :
b) si la période de référence (T) est plus proche de la période longue (T_{H}) que de la période courte (T_{L}), incrémenter la période courte (T_{L}) ;
c) si la période de référence (T) est plus proche de la période courte (T_{L}) que de la période longue (T_{H}), décrémenter la période longue (T_{H}) ;
d) si la période de référence (T) est supérieure à la période longue (T_{H}), incrémenter la période longue (T_{H}) ; et
e) si la période de référence (T) est inférieure à la période courte (T_{L}), décrémenter la période courte (T_{L}).

2. Procédé selon la revendication 1, caractérisé en ce que l'étape a) consiste à analyser un nombre prédéterminé des dernières différences de phase successives entre le signal prédéterminé (Fint) et le signal de référence (SYNC) et en ce que les conditions des étapes b) à e) sont réalisées respectivement si, parmi les dernières différences de phase :
- le nombre d'avances de phase est plus élevé que le nombre de retards de phase ;
- le nombre de retards de phase est plus élevé que le nombre d'avances de phase ;
- il n'y a pas de retards de phase ; et
- il n'y a pas d'avances de phase.

3. Procédé selon la revendication 2, caractérisé en ce qu'il comprend les étapes suivantes :
- si le nombre d'avances de phase successives est supérieur à un nombre prédéterminé, incrémenter la période longue (T_{H}) ; et
- si le nombre de retards de phase successifs est supérieur au nombre prédéterminé, décrémenter la période courte (T_{L}).

4. Procédé selon l'une quelconque des revendications 1 à 3, caractérisé en ce qu'il comprend les étapes consistant à comparer les périodes longue et courte (T_{H}, T_{L}) et à inhiber la décrémentation de la période longue et l'incrémentation de la période courte quand la différence entre ces périodes est inférieure à un seuil prédéterminé.

5. Procédé selon l'une quelconque des revendications 1 à 4, caractérisé en ce qu'il comprend les étapes suivantes :
- comparer la période longue (T_{H}) à une période maximale et inhiber l'incrémentation de la période longue si ces périodes sont égales ; et
- comparer la période courte (T_{L}) à une période minimale et inhiber la décrémentation de la période courte si ces périodes sont égales.

6. Dispositif de synchronisation d'un signal interne (Fint) sur un signal de référence (SYNC), ces signaux comprenant chacun des impulsions se produisant normalement à une fréquence nominale, comprenant :
- un comparateur de phase (10) délivrant un signal de comparaison de phase (SON) à un état logique prédéterminé si la phase du signal interne (Fint) est en avance par rapport à celle du signal de synchronisation (SYNC), et à un état logique complémentaire dans le cas contraire ; et
- un diviseur de fréquence programmable (13) alimenté par une horloge (CK) et délivrant le signal interne (Fint) ; caractérisé en ce qu'il comprend :
- un multiplexeur (14) fournissant au diviseur (13) pour le programmer un nombre binaire haut (N_{H}) si ledit signal de comparaison est à l'état prédéterminé, et un nombre binaire bas (N_{L}) dans le cas contraire ;
- des moyens (34) pour mémoriser séquentiellement les derniers états du signal de comparaison (SGN) ;
- des premiers moyens de comptage/décomptage (16) cadencés par le signal interne (Fint) et fournissant ledit nombre binaire haut (N_{H}) au multiplexeur ;
- des premiers moyens de détection (43) mettant les premiers moyens de comptage/décomptage (16) en position de décomptage lorsque les derniers états mémorisés du signal de comparaison (SGN) présentent un seul état à l'état prédéterminé ;
- des deuxièmes moyens de comptage/décomptage (17) cadencés par le signal interne (Fint) et fournissant ledit nombre binaire bas (N_{L}) au multiplexeur (14) ; et
- des deuxièmes moyens de détection (46) mettant les deuxièmes moyens de comptage/décomptage (17) en position de comptage lorsque les derniers états mémorisés du signal de comparaison (SGN) présentent un seul état à l'état complémentaire.

7. Dispositif selon la revendication 6, caractérisé en ce qu'il comprend :
- des troisièmes moyens de détection (37) mettant les premiers moyens de comptage/décomptage (16) en position de comptage lorsque les états mémorisés du signal de comparaison sont tous à l'état prédéterminé ; et
- des quatrièmes moyens de détection (40) mettant les deuxièmes moyens de comptage/décomptage (17) en position de décomptage lorsque les états mémorisés du signal de comparaison sont tous à l'état complémentaire.

8. Dispositif selon l'une des revendications 6 et 7, caractérisé en ce qu'il comprend un premier comparateur (54) des nombres binaires haut et bas (N_{H}, N_{L}) et mettant les premiers et deuxièmes moyens de comptage/décomptage (16, 17) en position de repos si le nombre haut est inférieur ou égal au nombre bas.

9. Dispositif selon l'une quelconque des revendications 6 à 8, caractérisé en ce qu'il comprend :
- un deuxième comparateur (50) du nombre binaire haut (N_{H}) à un nombre binaire maximum et mettant les premiers moyens de comptage/décomptage (16) à la position de repos en cas de dépassement ; et
- un troisième comparateur (52) du nombre binaire bas (N_{L}) à un nombre minimum et mettant les deuxièmes moyens de comptage/décomptage (17) à la position de repos en cas de dépassement.

10. Dispositif selon l'une quelconque des revendications 6 à 9, caractérisé en ce que le diviseur programmable (13) comprend un diviseur (60) par deux nombres distincts dont l'un ou l'autre est sélectionné par le signal de sortie d'un générateur d'impulsions (64) programmé par le nombre fourni par le multiplexeur (14).

## Patentansprüche

1. Verfahren zum Synchronisieren eines vorgegebenen Signals (Fint) bezüglich eines Bezugssignals (SYNC) mit einer Bezugsperiode (T), wobei das vorgegebene Signal eine lange Periode (T_{H}) oder eine kurze Periode (T_{L}) aufweist, zwischen denen normalerweise die Bezugsperiode (T) liegt, mit folgenden Verfahrensschritten:
a) Analysieren der Dauer der Bezugsperiode (T) im Verhältnis zur Dauer der langen (T_{H}) und der kurzen (T_{L})-Perioden;
**gekennzeichnet** durch die folgenden weiteren Verfahrensschritte:
b) wenn die Bezugsperiode (T) näher bei der langen Periode (T_{H}) als bei der kurzen Periode (T_{L}) liegt, Inkrementieren der kurzen Periode (T_{L});
c) wenn die Bezugsperiode (T) näher bei der kurzen Periode (T_{L}) als bei der langen Periode (T_{H}) liegt, Dekrementieren der langen Periode (T_{H});
d) wenn die Bezugsperiode (T) größer als die lange Periode (T_{H}) ist, Inkrementieren der langen Periode (T_{H}); und
e) wenn die Bezugsperiode (T) kleiner als die kurze Periode (T_{L}) ist, Dekrementieren der kurzen Periode (T_{L}).

2. Verfahren nach Anspruch 1, dadurch **gekennzeichnet**, daß der Schritt a) aus der Analyse einer vorgegebenen Anzahl von letzen aufeinanderfolgenden Phasen-Differenzen zwischen dem vorgegebenen Signal (Fint) und dem Bezugssignal (SYNC) besteht, und daß die Anforderungen der Schritte b) bis e) erfüllt sind, wenn unter den letzen Phasendifferenzen jeweils
- die Anzahl der voreilenden Phasen höher ist als die Anzahl der nacheilenden Phasen;
- die Anzahl der nacheilenden Phasen höher ist als die Anzahl der voreilenden Phasen;
- es keine nacheilenden Phasen gibt;
- es keine voreilenden Phasen gibt.

3. Verfahren nach Anspruch 2, **gekennzeichnet** durch die weiteren Verfahrensschritte:
- wenn die Anzahl der aufeinanderfolgenden voreilenden Phasen höher als eine vorgegebene Zahl ist, Inkrementieren der langen Periode (T_{H}); und
- wenn die Anzahl der aufeinanderfolgenden nacheilenden Phasen höher als die vorgegebene Zahl ist, Dekrementieren der kurzen Periode (T_{L}).

4. Verfahren nach einem der Ansprüche 1 bis 3, **gekennzeichnet** durch die folgenden Verfahrensschritte:
- Vergleichen der langen und kurzen (T_{H}, T_{L}) Perioden; und
- Sperren des Dekrementierens der langen Periode und des Inkrementierens der kurzen Periode, wenn die Differenz zwischen diesen Perioden geringer ist als ein vorgegebener Schwellwert.

5. Verfahren nach einem der Ansprüche 1 bis 4, **gekennzeichnet** durch die folgenden Verfahrensschritte:
- Vergleichen der langen Periode (T_{H}) mit einer maximalen Periode und Sperren des Inkrementierens der langen Periode, wenn diese Perioden gleich sind; und
- Vergleichen der kurzen Periode (T_{L}) mit einer minimalen Periode und Sperren des Dekrementierens der kurzen Periode, wenn diese Perioden gleich sind.

6. Vorrichtung zum Synchronisieren eines internen Signals (Fint) im Verhältnis zu einem Bezugssignal (SYNC), wobei die Signale jeweils Impulse umfassen, die normalerweise bei einer Nennfrequenz auftreten, mit:
- einem Phasenvergleicher (10), der ein Phasenvergleichssignal (SGN) bei einem vorgegebenen logischen Zustand vorsieht, wenn die Phase des internen Signals (Fint) der Phase des Synchronisierungssignals (SYNC) voreilt und anderenfalls ein Signal mit einem komplementären logischen Zustand vorsieht;
- einem programmierbaren Frequenzteiler (13), der mit einem Takt (CK) gespeist wird und das interne Signal (Fint) vorsieht;
**gekennzeichnet** durch:
- einen Multiplexer (14), der eine hohe binäre Zahl (N_{H}) an den Teiler (13) liefert, um diesen zu programmieren, wenn das Vergleichssignal den vorgegebenen Zustand hat, und anderenfalls eine niedrige binäre Zahl (N_{L}) vorsieht;
- eine Vorrichtung (34) zum sequentiellen Speichern der letzten Zustände des Vergleichssignals (SGN);
- eine erste Aufwärts-Abwärts-Zählvorrichtung (16), welche mit dem internen Signal (Fint) getaktet wird und die hohe binäre Zahl (N_{H}) an den Multiplexer liefert;
- eine erste Erfassungsvorrichtung (43), welche die erste Aufwärts-Abwärts-Zählvorrichtung (16) in die Abwärtszählposition setzt, wenn die letzten gespeicherten Zustände des Vergleichssignals (SGN) einen einzigen Zustand bei dem vorgegebenen Zustand haben;
- eine zweite Aufwärts-Abwärts-Zählvorrichtung (17), die mit dem internen Signal (Fint) getaktet wird und die niedrige binäre Zahl (N_{L}) an den Multiplexer liefert; und
- eine zweite Erfassungsvorrichtung (46), welche die zweite Aufwärts-Abwärts-Zählvorrichtung (17) in die Aufwärts-Zählposition setzt, wenn die letzten gespeicherten Zustände des Vergleichssignals (SGN) einen einzigen Zustand bei dem komplementären Zustand haben.

7. Vorrichtung nach Anspruch 6, **gekennzeichnet** durch
- eine dritte Erfassungsvorrichtung (37), welche die erste Aufwärts-Abwärts-Zählvorrichtung (16) in die Aufwärts-Zählposition setzt, wenn alle gespeicherten Zustände des Vergleichssignals auf dem vorgegebenen Zustand sind; und
- eine vierte Erfassungsvorrichtung (40), welche die zweite Aufwärts-Abwärts-Zählvorrichtung (17) in die Abwärts-Zählposition setzt, wenn alle gespeicherten Zustände des Vergleichssignals bei dem komplementären Zustand sind.

8. Vorrichtung nach Anspruch 6 oder 7, **gekennzeichnet** durch einen ersten Vergleicher (54) zum Vergleichen der hohen und niedrigen binären Zahlen (N_{H}, N_{L}) und zum Setzen der ersten und der zweiten Aufwärts-Abwärts-Zählvorrichtung (16,17) in einen Stand-by-Zustand, wenn die hohe Zahl niedriger als oder gleich groß wie die niedrige Zahl ist.

9. Vorrichtung nach einem der Ansprüche 6 bis 8, **gekennzeichnet** durch:
- einen zweiten Vergleicher (50), welcher die hohe binäre Zahl (N_{H}) mit einer maximalen binären Zahl vergleicht und die Aufwärts-Abwärts-Zählvorrichtung (16) in den Stand-by-Zustand setzt, wenn diese Zahl überschritten wird; und
- einen dritten Vergleicher (52), der die niedrige binäre Zahl (N_{L}) mit einer minimalen Zahl vergleicht und die zweite Aufwärts-Abwärts-Zählvorrichtung (17) in den Stand-by-Zustand setzt, wenn diese Zahl unterschritten wird.

10. Vorrichtung nach einem der Ansprüche 6 bis 9, dadurch **gekennzeichnet**, daß der programmierbare Teiler (13) einen Teiler (60) durch zwei bstimmte Zahlen aufweist, von denen beide durch das Ausgangssignal eines Impulsgenerators (64) ausgewählt werden, der mit der von dem Multiplexer (14) gelieferten Zahl programmiert ist.

## Claims

1. A method for synchronizing a predetermined signal (Fint) with respect to a reference signal (SYNC) having a reference period (T), said predetermined signal having a long period (T_{H}) or a short period (T_{L}) between which said reference period (T) is normally included, comprising the steps of:
a) analyzing the duration of said reference period (T) with respect to the duration of the long (T_{H}) and short (T_{L}) periods;
characterized in that it comprises the following steps:
b) if the reference period (T) is closer to the long period (T_{H}) than the short period (T_{L}), incrementing the short period (T_{L});
c) if the reference period (T) is closer to the short period (T_{L}) than the long period (T_{H}), decrementing the long period (T_{H});
d) if the reference period (T) is higher than the long period (T_{H}), incrementing the long period (T_{H}); and
e) if the reference period (T) is lower than the short period (T_{L}), decrementing the short period (T_{L}).

2. A method according to claim 1, characterized in that step a) consists in analyzing a predetermined number of the latest successive differences of phase between said predetermined signal (Fint) and said reference signal (SYNC) and wherein the requirements of steps b) to e) are met if, respectively, among the last phase differences:
- the number of phases in advance is higher than the number of lagged phases;
- the number of lagged phases is higher than the number of phases in advance;
- there is no phase lag; and
- there is no phase advance.

3. A method according to claim 2, characterized in that it comprises the following steps:
- if the number of successive phases in advance is higher than a predetermined number, incrementing the long period (T_{H}); and
- if the number of successive phase lags is higher than the predetermined number, decrementing the short period (T_{L}).

4. A method according to any of claims 1 to 3, characterized in that it comprises the following steps:
- comparing the long and short (T_{H}, T_{L}) periods; and
- inhibiting the decrementation of the long period and the incrementation of the short period when the difference between these periods is lower than a predetermined threshold.

5. A method of any of claims 1 to 4, characterized in that it comprises the following steps:
- comparing the long period (T_{H}) with a maximum period and inhibiting the incrementation of the long period if said periods are equal; and
- comparing the short period (T_{L}) with a minimum period and inhibiting the decrementation of the short period if said periods are equal.

6. A device for synchronizing an internal signal (Fint) with respect to a reference signal (SYNC), said signals each comprising pulses normally occurring at a rated frequency, comprising:
- a phase comparator (10) providing a phase comparison signal (SGN) at a predetermined logic state if the phase of said internal signal (Fint) is in advance with respect to the phase of the synchronization signal (SYNC), and at a complementary logic state otherwise;
- a programmable frequency divider (13) fed by a clock (CK) and providing said internal signal (Fint);
characterized in that it comprises:
- a multiplexer (14) providing to said divider (13), in order to program it, a high binary number (N_{H}) if said comparison signal is at the predetermined state, and a low binary number (N_{L}), otherwise;
- means (34) for sequentially storing the latest states of the comparison signal (SGN);
- first up-down counting means (16) clocked by said internal signal (Fint) and providing said high binary number (N_{H}) to the multiplexer;
- first detection means (43) setting the first up-down counting means (16) in down-counting position when the latest stored states of the comparison signal (SGN) have a single state at the predetermined state;
- second up-down counting means (17), clocked by said internal signal (Fint) and providing said low binary number (N_{L}) to said multiplexer (14); and
- second detection means (46) setting said second up-down counting means (17) in up-counting position when the latest stored states of said comparison signal (SGN) have a single state at the complementary state.

7. A device according to claim 6, characterized in that it comprises:
- third detection means (37) setting the first up-down counting means (16) in up-counting position when all the stored states of said comparison signal are at the predetermined state; and
- fourth detection means (40) setting the second up-down counting means (17) to down-counting position when all the stored states of said comparison signal are at the complementary state.

8. A device according to claim 6 or 7, characterized in that it comprises a first comparator (54) for comparing the high and low binary numbers (N_{H}, N_{L}) and setting said first and second up-down counting means (16, 17) in standby state if the high number is lower than or equal to the low number.

9. A device according to any of claims 6 to 8, characterized in that it comprises:
- a second comparator (50) comparing said high binary number (N_{H}) with a maximum binary number and setting said counting up-down means (16) in standby state if said number is exceeded; and
- a third comparator (52) comparing said low binary number (N_{L}) with a minimum number and setting said second up-down counting means (17) in standby state if said number is exceeded.

10. A device according to any of claims 6 to 9, characterized in that said programmable divider (13) comprises a divider (60) by two distinct numbers, either one is selected by the output signal of a pulse generator (64) programmed by the number provided by the multiplexer (14).
